# EUROPEAN PATENT APPLICATION

(11) **EP 4 709 057 A1**
(43) Date of publication of application: **11.03.2026**
(21) Application number: 24802635.3
(22) Date of filing: 27.03.2024
(51) Int. Cl.: H05K 1/02

(54) **FLOW-THROUGH HEAT DISSIPATION APPARATUS AND CIRCUIT BOARD**

(30) Priority: 11.05.2023 CN 202310531486
(71) Applicant: ZTE Corporation, Shenzhen, Guangdong 518057 (CN)
(72) Inventor: LU, Xian, Shenzhen, Guangdong 518057 (CN)
(74) Representative: Ziebig Hengelhaupt Intellectual Property Attorneys Patentanwaltskanzlei PartGmbB
(86) International application number: PCT/CN2024/084161
(87) International publication number: WO 2024/230347

(57) **Abstract**

Disclosed in the present application is a flow-through heat dissipation apparatus which is applied to a circuit board. The flow-through heat dissipation apparatus comprises a flow-through component and a heat dissipation component; the heat dissipation component is arranged on the first surface of the flow-through component, the second surface of the flow-through component is used for being connected to a circuit layer of the circuit board, and the second surface and the first surface are arranged opposite to each other in the first direction; at least part of the area of the flow-through heat dissipation apparatus is provided with a heat dissipation channel.

## Description

### CROSS-REFERENCE TO RELATED APPLICATIONS

The present application is proposed based on and claims priority to Chinese Application No. 202310531486.0, filed with the Chinese Patent Office on May 11, 2023, with the title "FLOW-THROUGH HEAT DISSIPATION APPARATUS AND CIRCUIT BOARD", the disclosure of which is hereby incorporated by reference in its entirety.

### TECHNICAL FIELD

The present application belongs to the technical field of surface mount devices, electrical components, etc., and specifically relates to a flow-through heat dissipation apparatus and a circuit board.

### BACKGROUND

The operation of each chip on a Printed Circuit Board (PCB) depends on the functionality of its power supply network. However, due to factors such as processing, the impedance of the surface layer of PCB is difficult to control. This results in high current loss and heat generation during power transmission through the power supply network. This heat cannot be quickly dissipated, easily leading to serious consequences such as PCB overheating or even burnout.

### SUMMARY

The embodiments of the present application aim to provide a flow-through heat dissipation apparatus and circuit board that can address the problems of high current loss and poor heat dissipation during PCB operation in related technologies.

The embodiments of the present application provide a flow-through heat dissipation apparatus, which is applied to a circuit board, the flow-through heat dissipation apparatus comprising: a flow-through component and a heat dissipation component; the heat dissipation component is arranged on a first surface of the flow-through component, a second surface of the flow-through component is used for being connected to a circuit layer of the circuit board, the second surface and the first surface are arranged opposite to each other in a first direction; at least part of the region of the flow-through heat dissipation apparatus is provided with a heat dissipation channel.

The embodiments of the present application further provide a circuit board comprising: a circuit board body and the flow-through heat dissipation apparatus described above; the flow-through heat dissipation apparatus is connected to the circuit board body.

### BRIEF DESCRIPTION OF DRAWINGS

Fig. 1 is a front view of a flow-through heat dissipation apparatus disclosed in an embodiment of the present application;
Fig. 2 is a schematic structural diagram of a first type of flow-through heat dissipation apparatus disclosed in an embodiment of the present application;
Fig. 3 is a left side view of the first type of flow-through heat dissipation apparatus disclosed in an embodiment of the present application;
Fig. 4 is a schematic structural diagram of a second type of flow-through heat dissipation apparatus disclosed in an embodiment of the present application;
Fig. 5 is a left side view of the second type of flow-through heat dissipation apparatus disclosed in an embodiment of the present application;
Fig. 6 is a front view of a flow-through heat dissipation apparatus with a first type of heat dissipation channel disclosed in an embodiment of the present application;
Fig. 7 is a front view of a flow-through heat dissipation apparatus with a second type of heat dissipation channel disclosed in an embodiment of the present application;
Fig. 8 is a front view of a flow-through heat dissipation apparatus with a third type of heat dissipation channel disclosed in an embodiment of the present application;
Fig. 9 is a front view of a flow-through heat dissipation apparatus with a fourth type of heat dissipation channel disclosed in an embodiment of the present application;
Fig. 10 is a left side view of a flow-through heat dissipation apparatus with a heat dissipation channel opened in a heat dissipation component disclosed in an embodiment of the present application;
Fig. 11 is a left side view of the first type of flow-through heat dissipation apparatus with multiple heat dissipation channels disclosed in an embodiment of the present application;
Fig. 12 is a left side view of the second type of flow-through heat dissipation apparatus with multiple heat dissipation channels disclosed in an embodiment of the present application;
Fig. 13 is a left side view of the third type of flow-through heat dissipation apparatus with multiple heat dissipation channels disclosed in an embodiment of the present application;
Fig. 14 is a left side view of the fourth type of flow-through heat dissipation apparatus with multiple heat dissipation channels disclosed in an embodiment of the present application;
Fig. 15 is a front view of the surface layer, copper foil layer, and solder resist layer of the circuit board disclosed in an embodiment of the present application;
Fig. 16 is a top view of the surface layer, copper foil layer, and solder resist layer of the circuit board disclosed in an embodiment of the present application;
Fig. 17 is a schematic diagram of the modeling of the flow-through heat dissipation apparatus disclosed in an embodiment of the present application;
Fig. 18 is a schematic diagram of the temperature simulation modeling of the flow-through heat dissipation apparatus disclosed in an embodiment of the present application;
Fig. 19 is a schematic diagram of the temperature simulation results of the flow-through heat dissipation apparatus disclosed in an embodiment of the present application;
Fig. 20 is a schematic diagram of the temperature simulation results of a flow-through structure in the related art.

### Explanation of reference numerals:

100-flow-through heat dissipation apparatus; 110-flow-through component; 111-first surface; 112-second surface; 120-heat dissipation component; 121-inner concave surface; 130-heat dissipation channel; 131-air inlet; 132-air outlet; A-windward surface; B-leeward surface;
200-circuit board body; 210-surface layer; 220-copper foil layer; 221-pad portion; 230-solder resist layer; 231-window.

### DETAILED DESCRIPTION

The technical solutions in the embodiments of the present application will be described clearly below in conjunction with the drawings in the embodiments of the present application. Obviously, the described embodiments are part of the embodiments of the present application, not all of them. Based on the embodiments in the present application, all other embodiments obtained by those skilled in the art belong to the protection scope of the present application.

The terms "first", "second", etc. in the specification and claims of the present application are used to distinguish similar objects, and are not used to describe a specific order or sequence. It should be understood that data used in this way can be interchangeable where appropriate, so that the embodiments of the present application can be implemented in an order other than those illustrated or described here, and the objects distinguished by "first", "second", etc. are generally of one type, and the number of objects is not limited. For example, the first object can be one or more. In addition, "and/or" in the specification and claims represents at least one of the connected objects, and the character "/" generally indicates that the objects associated with each other are in an "or" relationship.

The following describes the embodiments of the present application in detail through specific embodiments and their application scenarios, with reference to the accompanying drawings.

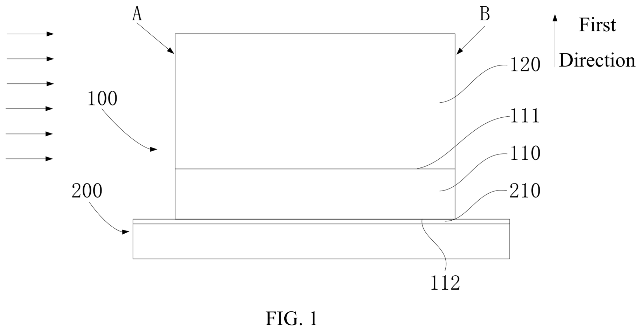

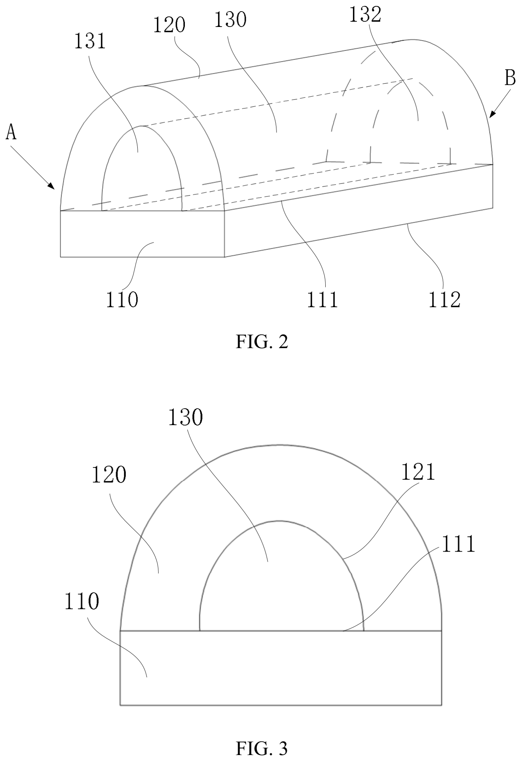

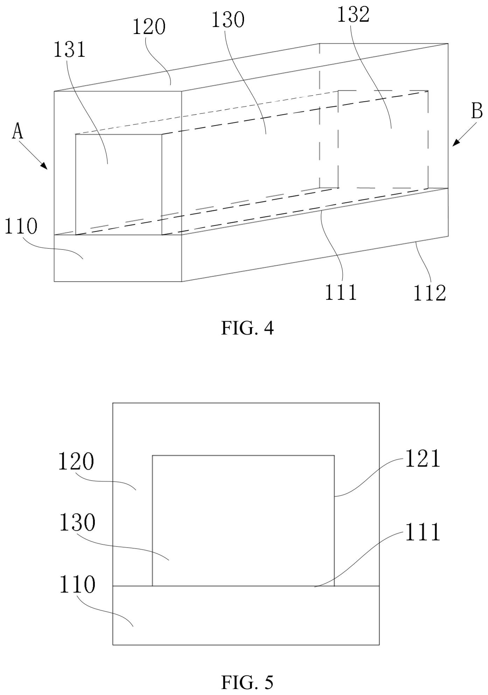

Referring to Figs. 1 to 20, the embodiments of the present application disclose a flow-through heat dissipation apparatus 100 for dissipating current and dissipating heat through a circuit board, thereby reducing the circuit board's current impedance and achieving effective heat dissipation. The disclosed flow-through heat dissipation apparatus 100 comprises a flow-through component 110 and a heat dissipation component 120. The flow-through component 110 facilitates current flow and conducts electricity, facilitating smooth current flow and reducing impedance; the heat dissipation component 120 dissipates heat from the circuit board, preventing the circuit board from overheating during operation, which could affect the lifespan of the circuit board and its electrical components.

Referring to Fig. 1, in some embodiments, the heat dissipation component 120 is arranged on the first surface 111 of the flow-through component 110, the second surface 112 of the flow-through component 110 is used for being connected to a circuit layer of the circuit board, the second surface 112 and the first surface 111 are arranged opposite to each other in a first direction. For example, the flow-through component 110 can be in the form of a plate, sheet, or block to facilitate adaptation to different application environments. It should be noted that the first direction is the direction perpendicular to the circuit board. When the flow-through heat dissipation apparatus 100 is in conjunction with the circuit board, the second surface 112 is connected to the circuit layer, and the first surface 111 is opposite to the circuit layer.

Since the heat dissipation component 120 is arranged on the first surface 111 of the flow-through component 110, the heat transferred from the circuit board to the flow-through component 110 can be transferred through the flow-through component 110 to the heat dissipation component 120, and ultimately the heat is dissipated by the heat dissipation component 120, thereby cooling the circuit board.

To enhance the heat dissipation effect, at least part of the region of the flow-through heat dissipation apparatus 100 can be provided with a heat dissipation channel 130. In this way, as the surrounding air flows, it will pass through the heat dissipation channel 130, causing the heat of the flow-through heat dissipation apparatus 100 to follow the air flow in the heat dissipation channel 130, thereby accelerating heat dissipation and preventing heat from accumulating within the flow-through heat dissipation apparatus 100 and affecting the heat dissipation of the circuit board.

It should be noted here that the heat dissipation channel 130 can be set in a local region of the flow-through heat dissipation apparatus 100, which can not only dissipate heat but also reduce the impact on the strength of the flow-through heat dissipation apparatus 100. Of course, the heat dissipation channel 130 can also be distributed in multiple regions of the flow-through heat dissipation apparatus 100 to improve the heat dissipation effect.

In the embodiment of the present application, the flow-through component 110 is connected to the circuit layer of the circuit board to increase the overall conductive cross-sectional area of the circuit board, thereby reducing the equivalent resistance at the region of the circuit board in the flow-through component 110. Compared to conducting electricity solely through the circuit layers of the circuit board, the embodiment of the present application utilizes the flow-through component 110 connected in parallel with the circuit layers, which effectively reduces the impedance of current flow, thereby reducing current losses of current flow and reducing heat generated by the circuit board, effectively alleviating the problem of high circuit board temperatures. Since the heat dissipation component 120 is arranged on the first surface 111 of the flow-through component 110, the heat transferred from the circuit board to the flow-through component 110 is transferred to the heat dissipation component 120 and dissipated by the heat dissipation component 120 to achieve the purpose of dissipating heat from the circuit board; and, at least part of the region of the flow-through heat dissipation apparatus 100 is provided with a heat dissipation channel 130. In this case, the air around the flow-through heat dissipation apparatus 100 can flow through the heat dissipation channel 130, thereby accelerating the dissipation of heat, and further improving the heat dissipation efficiency of the circuit board, so as to ensure the temperature of the circuit board is not too high during operation, and to a certain extent, extend the service life of the circuit board.

In the embodiment of the present application, the flow-through heat dissipation apparatus 100 has a windward surface A and a leeward surface B, sequentially arranged along the airflow direction, as shown in Fig. 1. The airflow direction is perpendicular to the first direction. It should be noted that the windward surface A can be understood as the surface that first contacts the airflow, and the leeward surface B can be understood as the surface that last contacts the airflow. That is, the airflow flows from the windward surface A toward the leeward surface B.

For example, when the circuit board is placed horizontally, the first direction is the up-down direction. The flow-through heat dissipation apparatus 100 can be arranged on the upper surface of the circuit board, the airflow can flow horizontally, allowing the airflow to contact the flow-through heat dissipation apparatus 100 and remove heat transferred from the circuit board to the flow-through heat dissipation apparatus 100, thereby achieving heat dissipation from the circuit board.

To enable airflow into and out of the heat dissipation channel 130, the heat dissipation channel 130 may comprise an air inlet 131 and an air outlet 132. The air inlet 131 and the air outlet 132 are respectively located at either end of the heat dissipation channel 130, with the air inlet 131 located at the windward surface A and the air outlet 132 located at the leeward surface B. This arrangement allows airflow to flow into the heat dissipation channel 130 through the air inlet 131 upon reaching the windward side A, generating heat exchange within the heat dissipation channel 130. By this arrangement, when the airflow flows to the windward surface A, it can flow into the heat dissipation channel 130 through the air inlet 131, and generate heat exchange in the heat dissipation channel 130, so that the heat dissipation component 120 absorbs the heat of the circuit board and transfers it to the airflow, causing the airflow to heat up. The heated airflow flows along the heat dissipation channel 130 to the leeward surface B, and is finally discharged through the air outlet 132, thereby realizing the dissipation of heat and achieving the heat dissipation effect on the circuit board.

In some embodiments, the extension direction of the heat dissipation channel 130 is used to form a preset angle with the airflow direction. The preset angle ranges from 0° to 80°, comprising, for example, 0°, 10°, 20°, 30°, 45°, 50°, 60°, 75°, 80°, etc. Of course, other degrees can also be used, which is not specifically limited here.

Based on the above configuration, the extension direction of the heat dissipation channel 130 can be parallel to the airflow direction or inclined relative to the airflow direction, so as to meet the heat dissipation requirements under different working conditions.

It should be noted that when the extension direction of the heat dissipation channel 130 is parallel to the airflow direction, that is, when the preset angle is 0°, in this case, the air flow can flow through the heat dissipation channel 130 more smoothly, and the flow rate is relatively large, which can improve the heat dissipation effect to a certain extent and further enhance the heat dissipation effect on the circuit board.

When the extension direction of the heat dissipation channel 130 is inclined relative to the airflow direction, that is, when the preset angle is greater than 0°, in this case, a part of the airflow may enter the heat dissipation channel 130, while another part flows through the outside of the heat dissipation channel 130. In this way, although the flow rate of the airflow in the heat dissipation channel 130 is reduced, the airflow contacted with the outer wall of the heat dissipation channel 130, thereby increasing the contact area between the airflow and the heat dissipation component 120, which can also improve the heat dissipation effect to a certain extent.

In a more specific embodiment, the preset angle is 0°, which can not only ensure a better heat dissipation effect, but also minimize the resistance of the heat dissipation channel 130 to the airflow, thereby ensuring the smoothness of the airflow in the heat dissipation channel 130 and reducing wind noise.

To facilitate the entry of airflow into the heat dissipation channel 130, when designing the heat dissipation channel 130, the cross-sectional area of the air inlet 131 can be made greater than or equal to that of the air outlet 132. The cross-sectional area here refers to the projected area of the heat dissipation channel 130 on a plane perpendicular to its own extension direction.

When the cross-sectional area of the air inlet 131 is larger than that of the air outlet 132, it is equivalent to expanding the air inlet 131, which allows more airflow to enter the heat dissipation channel 130. To a certain extent, more heat can be taken away from the heat dissipation component 120, thereby improving the heat dissipation effect.

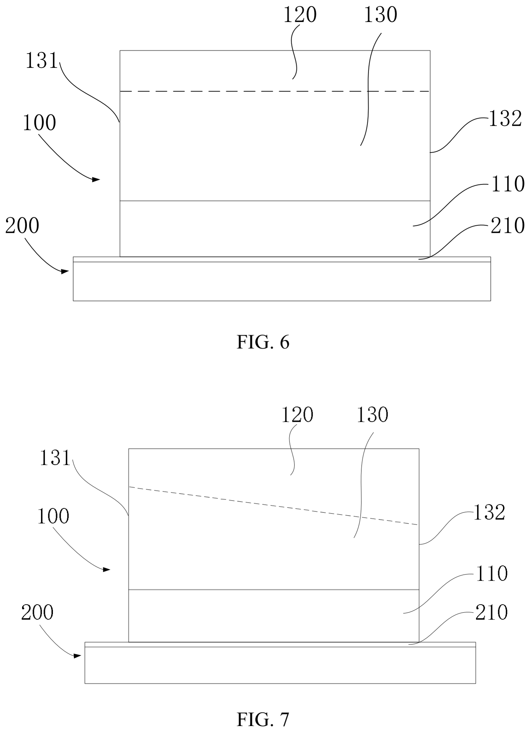

In some embodiments, the cross-sectional area of the heat dissipation channel 130 gradually decreases from the air inlet 131 to the air outlet 132, as shown in Fig. 7. This arrangement can not only help more airflow enter the heat dissipation channel 130 to improve the heat dissipation effect, but also accelerate the flow rate of the airflow in the heat dissipation channel 130, thereby increasing the heat dissipation rate and also improving the heat dissipation effect to a certain extent.

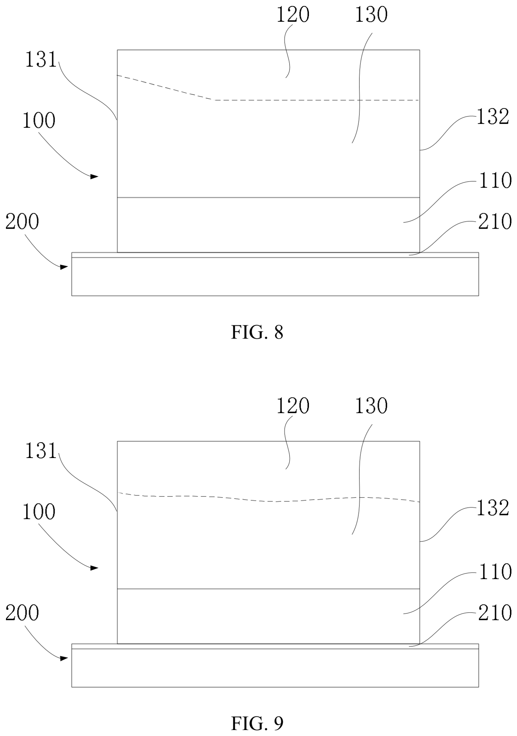

Of course, the cross-sectional area of the air inlet 131 being larger than that of the air outlet 132 can also mean that the cross-sectional area at the region of the air inlet 131 is larger while the cross-sectional area in other regions are equal, as shown in Fig. 8. Alternatively, it can mean that the cross-sectional area at the region of the air outlet 132 is smaller while the cross-sectional area in other regions are equal. The specific form is not limited.

The cross-sectional area of the air inlet 131 is equal to that of the air outlet 132, which can be as follows: the cross-sectional area of the heat dissipation channel 130 is equal at all locations in the direction from the air inlet 131 to the air outlet 132, as shown in Fig. 7. In this case, it can ensure that the airflow flows at a constant speed in the heat dissipation channel 130, and can also reduce wind noise while ensuring a good heat dissipation effect. Of course, there can also be other forms, which are not specifically limited here.

In some embodiments, the inner wall of the heat dissipation channel 130 may be a smooth surface. In this case, the wind resistance in the heat dissipation channel 130 can be reduced, and the wind noise can also be reduced, thereby making the airflow in the heat dissipation channel 130 smoother. For example, at least part of the inner wall of the heat dissipation channel 130 is a flat surface or a smooth curved surface. Of course, it can also be in other forms, which are not specifically limited here.

In other embodiments, the inner wall of the heat dissipation channel 130 may be a concave-convex surface, as shown in Fig. 9. In this case, the contact area between the airflow and the inner wall of the heat dissipation channel 130 can be increased, which can improve the heat exchange efficiency to a certain extent, thereby enhancing the heat dissipation effect. For example, at least part of the inner wall of the heat dissipation channel 130 may be provided with protrusions, depressions, etc. Of course, the entire inner wall of the heat dissipation channel 130 may also be a wavy surface. All the above methods can increase the contact area between the airflow and the inner wall, thereby improving the heat dissipation effect.

Since the heat dissipation component 120 is arranged on the first surface 111 of the flow-through component 110, the flow-through component 110 and the heat dissipation component 120 may together enclose the heat dissipation channel 130, as shown in Figs. 1 to 9. In this case, the airflow passing through the heat dissipation channel 130 can be brought into contact with both the flow-through component 110 and the heat dissipation component 120, so that the respective heat of the flow-through component 110 and the heat dissipation component 120 can be transferred to the airflow. At the same time, the heat of the flow-through component 110 will also be transferred to the heat dissipation component 120, and then transferred from the heat dissipation component 120 to the airflow. Based on this, multiple heat transfer paths can be realized, that is, the flow-through component 110 directly transfers heat to the airflow, and the flow-through component 110 transfers heat to the airflow and the external environment through the heat dissipation component 120. In this way, the heat dissipation effect can be improved.

In some embodiments, the heat dissipation component 120 may be a concave plate, the inner concave surface 121 of the concave plate towards the first surface 111, and the inner concave surface 121 and the first surface 111 enclose the heat dissipation channel 130. Exemplarily, the cross-section of the heat dissipation channel 130 enclosed by the inner concave surface 121 and the first surface 111 may be arched, semicircular, polygonal, etc. There is no specific limitation on the shape of the cross-section of the heat dissipation channel 130 here.

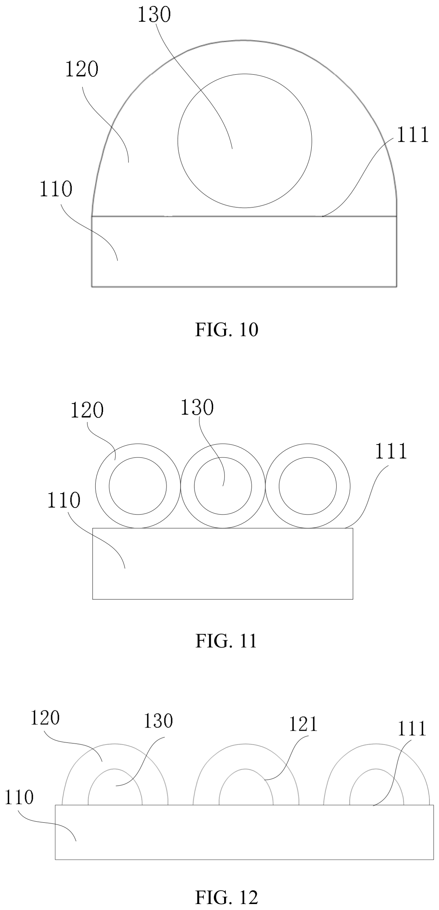

In the embodiment of the present application, the heat dissipation channel 130 may also be opened in the heat dissipation component 120, and the heat dissipation channel 130 passes through the heat dissipation component 120, so that the heat dissipation channel 130 and the heat dissipation component 120 can form an integrated structure, as shown in Fig. 10. In this case, when the airflow passes through the heat dissipation channel 130, it directly exchanges heat with the heat dissipation component 120 without directly exchanging heat with the flow-through component 110. As a result, the heat of the flow-through component 110 is indirectly transferred to the airflow through the heat dissipation component 120 and finally dissipated to the outside along with the airflow. This form can ensure the integrity of the heat dissipation channel 130 to prevent leakage, and the heat dissipation component 120 with the heat dissipation channel 130 is easy to manufacture, for example, by integral molding, which can shorten the manufacturing cycle.

In some embodiments, the heat dissipation component 120 may comprise at least one heat dissipation pipe, the lumen of the heat dissipation pipe is the heat dissipation channel 130. The at least one heat dissipation pipe can guide the airflow, enabling the airflow to absorb the heat transferred from the flow-through component 110 to the at least one heat dissipation pipe, thereby achieving a better heat dissipation effect.

Exemplarily, the cross-sectional shape of the lumen of the heat dissipation pipe may comprise a circle, an ellipse, or a polygon. Of course, other shapes are also possible as long as they can guide the airflow, and the specific shape is not limited here.

In some embodiments, the flow-through heat dissipation apparatus 100 may comprise one heat dissipation component 120, and the heat dissipation component 120 is provided with a plurality of heat dissipation channels 130. In this way, when the airflow passes through the plurality of heat dissipation channels 130, it can take away the heat from the same heat dissipation component 120 through the plurality of heat dissipation channels 130 respectively, thereby improving the heat dissipation efficiency. At the same time, the plurality of heat dissipation channels 130 can also increase the contact area with the airflow, which can also improve the heat dissipation efficiency.

In other embodiments, the flow-through heat dissipation apparatus 100 may comprise a plurality of heat dissipation components 120 arranged on the first surface 111, and each heat dissipation component 120 is provided with one heat dissipation channel 130, as shown in Figs. 11 to 14. In this way, the airflow can pass through the respective heat dissipation channels 130 of the plurality of heat dissipation components 120, taking away heat from the plurality of heat dissipation components 120 respectively, thereby improving the heat dissipation efficiency; at the same time, the plurality of heat dissipation components 120 can also increase the contact area with the environment, thus also improving the heat dissipation efficiency. It should be noted here that the arrangement forms of the plurality of heat dissipation components 120 on the first surface 111 and the shape of each heat dissipation component 120 are not limited to the forms recorded in Figs. 11 to 14, and can also be other forms, as long as they can play a role in heat dissipation. The specific forms will not be listed one by one.

In the embodiments of this application, the flow-through component 110 can be a metal patch or a metal plate, and the metal patch or metal plate is attached to the circuit layer. Using a metal patch or metal plate can not only ensure that there is a sufficiently large contact area between the flow-through component 110 and the circuit layer to improve the heat dissipation effect, but also ensure a good conductive effect between the two. The material of the flow-through component 110 may comprise pure metals or metal alloys, etc. For example, the flow-through component 110 may be made of copper or copper alloy materials.

In addition, the dimensions of the flow-through component 110 can be 3mm × 6mm × 0.8mm, 3mm × 4.5mm × 3mm, etc. Of course, other dimensions are also possible, and the specific dimensions can be set according to actual working conditions.

The flow-through heat dissipation apparatus 100 can be an integrally formed structure. In this case, the manufacturing of the flow-through heat dissipation apparatus 100 can be facilitated, and the manufacturing cycle can be shortened.

Of course, the flow-through component 110 and the heat dissipation component 120 can also be connected by welding. Specifically, the flow-through component 110 is attached to the surface of the circuit layer, and regions, such as the edges of the flow-through component 110, are fixed to the surface of the circuit layer by welding. On the one hand, this can ensure the firmness of the connection between the flow-through component 110 and the circuit layer; on the other hand, it can also ensure electrical conduction between the flow-through component 110 and the circuit layer, so as to form an integrated electrical conductor, which is beneficial to reducing the flow-through loss.

In addition, the flow-through component 110 and the heat dissipation component 120 can also be connected via conductive adhesive. Specifically, the conductive adhesive can be coated to at least one of the side of the flow-through component 110 facing away from the heat dissipation component 120 and the surface of the circuit layer, a certain pressure is applied to the flow-through component 110 to ensure that the flow-through component 110 and the surface of the circuit layer can be firmly bonded together through the conductive adhesive. With this configuration, on the one hand, the conductive adhesive can realize the fixed connection between the flow-through component 110 and the circuit layer and ensure the firmness of the connection; on the other hand, the conductive adhesive can also realize electrical conduction between the flow-through component 110 and the circuit layer, so as to form an integral conductor, which is beneficial to reducing flow-through loss.

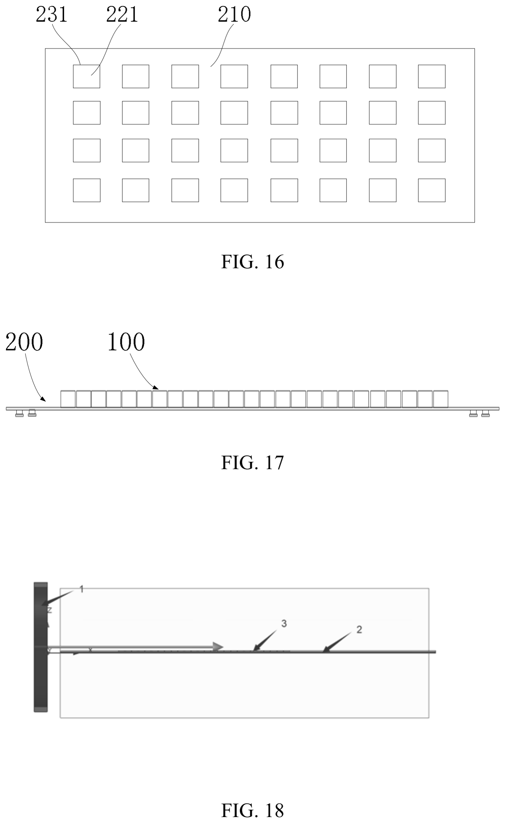

Based on the above-mentioned flow-through heat dissipation apparatus 100, the embodiment of the present application also discloses a circuit board, which comprises a circuit board body 200 and the above-mentioned flow-through heat dissipation apparatus 100, wherein the flow-through heat dissipation apparatus 100 is connected to the circuit board body 200, as shown in Fig. 17.

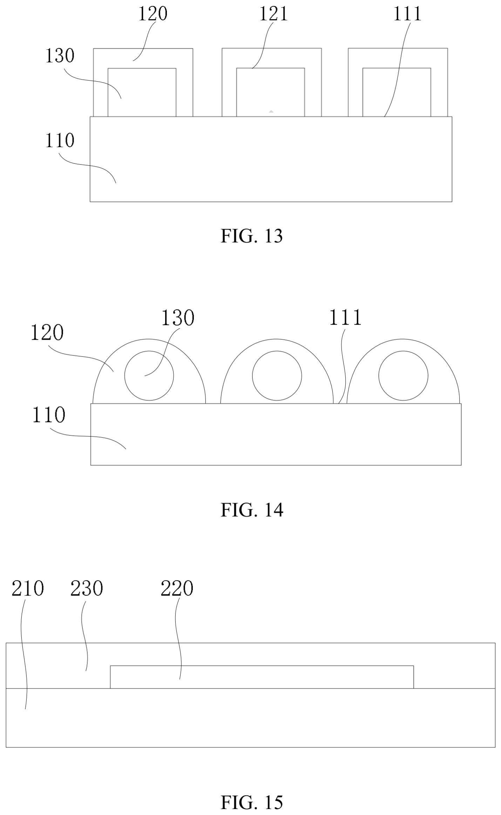

Referring to Figs. 15 and 16, in some embodiments, the circuit board body 200 may comprise a surface layer 210, a copper foil layer 220, and a solder resist layer 230, wherein the copper foil layer 220 is provided on the surface layer 210, and the copper foil layer 220 is a circuit layer provided with circuits, which serves the function of current flow-through, thereby being able to supply power to various electrical components on the circuit board. The solder resist layer 230 is provided on the copper foil layer 220, and the solder resist layer 230 is provided with a plurality of windows 231, the copper foil layer 220 forms a plurality of pad portions 221 at positions respectively opposite to the plurality of windows 231. Correspondingly, the circuit board comprises a plurality of flow-through heat dissipation apparatus 100, and the flow-through components 110 of each of the plurality of the flow-through heat dissipation apparatuses 100 are respectively connected to the plurality of pad portions 221.

Based on the above configuration, by connecting the flow-through component 110 of the flow-through heat dissipation apparatus 100 to the pad portion 221 of the copper foil layer 220, the overall current-carrying capacity of the circuit board can be effectively improved, and the heat generated by the circuit board can also be dissipated to achieve a heat dissipation effect. The solder resist layer 230 covers the surface of the copper foil layer 220, which can protect the copper foil layer 220, and provides clearance for the flow-through heat dissipation apparatus 100 to be connected to the copper foil layer 220 through the window 231.

Exemplarily, the solder resist layer 230 can be an ink layer, but of course, it can also be other layer structures, which are not specifically limited here. In addition, the solder resist layer 230 can be covered on the surface of the copper foil layer 220 by means of screen printing.

The embodiment of the present application also discloses a method for preparing a circuit board, which comprises the following steps.
1. Simulation. Based on the system design requirements, the power network of the circuit board is simulated. The simulation results show that it fails to meet the voltage drop and temperature rise requirements of the system design.
2. Design the size and shape of the flow-through heat dissipation apparatus 100.
3. On the copper foil layer 220 of the power network that needs optimization, add the package of the flow-through heat dissipation apparatus 100. Determine the number of flow-through heat dissipation apparatus 100 to be added according to the specifications of the copper foil layer 220, the current direction, or the position of hot spots, and rotate the placement direction of the flow-through heat dissipation apparatus 100 according to the wind direction of surface heat dissipation.
4. Output the photolithography file in a universal format with a suffix that can be recognized by the circuit board manufacturer.
5. Install the flow-through heat dissipation apparatus 100. After the circuit board is fabricated, the designed and fabricated flow-through heat dissipation apparatus 100 is installed in the pre-set position on the circuit board using reflow soldering in the fabrication workshop.

Fig. 17 shows a schematic diagram of a model of multiple flow-through heat dissipation apparatuses 100 connected in parallel. Each heat dissipation component 120 can be a rectangular parallelepiped structure, and the heat dissipation channel 130 has a rectangular cross-section. The overall dimension of the heat dissipation component 120 is 3mm × 6mm × 4mm, while the dimension of the heat dissipation channel 130 is 2mm × 6mm × 3mm.

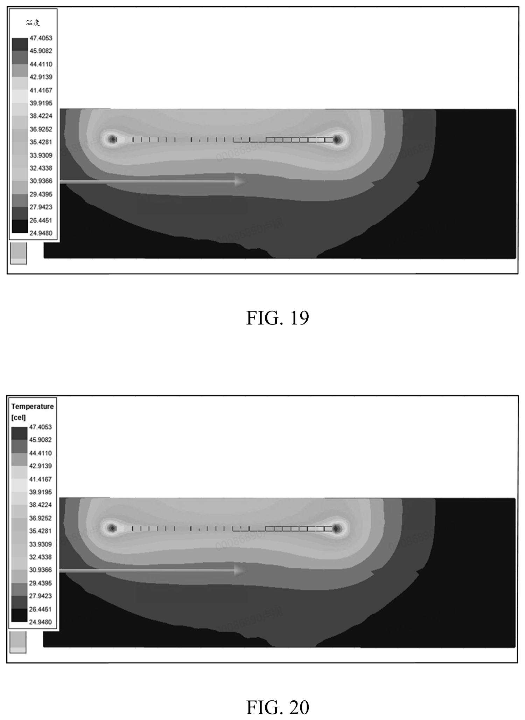

Under the simulation conditions shown in Fig. 18, 1 represents the fan model, 2 represents the multi-layer circuit board, and 3 represents the installation position of the flow-through heat dissipation apparatus 100. As shown in Figs. 19 and 20, when only the through-flow component 110 is provided with a current of 40A, the simulated voltage drop is 352mV, the hot spot temperature is 47.4°C, and the temperature rise is 22.4°C; when the through-flow heat dissipation component 120 is provided with a current of 40A, the simulated voltage drop is 276mV, the hot spot temperature is 42.5°C, and the temperature rise is 17.5°C. A comparison of the simulation results of voltage drop and temperature rise is shown in Table 1.

| | voltage drop | temperature rise |
|---|---|---|
| General flow-through block | 352mV | 22.4°C |
| Flow-through heat dissipation apparatus | 276mV | 17.5°C |
| Improvement ratio | 21.6% | 21.9% |

It can be seen from Table 1 that when the flow-through heat dissipation apparatus 100 in the embodiment of the present application is adopted, the voltage drop can be reduced by 21.6% and the temperature rise can be reduced by 21.9%, which has a significant improvement effect on the through-flow and heat dissipation of the circuit board.

In summary, in the embodiment of the present application, by arranging the heat dissipation component 120 on the flow-through component 110, the heat dissipation efficiency of the circuit board can be improved without changing the contact area between the flow-through component 110 and the circuit board, thereby improving the heat dissipation performance.

The embodiments of the present application are described above in conjunction with the accompanying drawings, but the present application is not limited to the above-mentioned specific implementation. The above-mentioned specific implementations are merely illustrative and not restrictive. Under the guidance of the present application, those skilled in the art can also make many forms without departing from the purpose of the present application and the scope of protection of the claims, all of which are within the protection of the present application.

## Claims

1. A flow-through heat dissipation apparatus, applied to a circuit board, the flow-through heat dissipation apparatus (100) comprising: a flow-through component (110) and a heat dissipation component (120);
the heat dissipation component (120) is arranged on a first surface (111) of the flow-through component (110), a second surface (112) of the flow-through component (110) is used for being connected to a circuit layer of the circuit board, the second surface (112) and the first surface (111) are arranged opposite to each other in a first direction;
at least part of the region of the flow-through heat dissipation apparatus (100) is provided with a heat dissipation channel (130).

2. The flow-through heat dissipation apparatus according to claim 1, wherein the flow-through heat dissipation apparatus (100) has a windward surface (A) and a leeward surface (B) sequentially arranged along an airflow direction, the airflow direction is perpendicular to the first direction;
the heat dissipation channel (130) comprises an air inlet (131) and an air outlet (132) respectively located at two ends, the air inlet (131) is located at the windward surface (A), the air outlet (132) is located at the leeward surface (B).

3. The flow-through heat dissipation apparatus according to claim 2, wherein an extension direction of the heat dissipation channel (130) is used to form a preset angle with the air flow direction, and the preset angle ranges from 0° to 80°.

4. The flow-through heat dissipation apparatus according to claim 2, wherein the cross-sectional area of the air inlet (131) is greater than or equal to the cross-sectional area of the air outlet (132).

5. The flow-through heat dissipation apparatus according to claim 4, wherein the cross-sectional area of the heat dissipation channel (130) gradually decreases in the direction from the air inlet (131) to the air outlet (132);
or, the cross-sectional area of the heat dissipation channel (130) is equal at all locations in the direction from the air inlet (131) to the air outlet (132).

6. The flow-through heat dissipation apparatus according to claim 1, wherein the inner wall of the heat dissipation channel (130) is a smooth surface or a concave-convex surface.

7. The flow-through heat dissipation apparatus according to any one of claims 1 to 6, wherein the flow-through component (110) and the heat dissipation component (120) together enclose the heat dissipation channel (130).

8. The flow-through heat dissipation apparatus according to claim 7, wherein the heat dissipation component (120) is a concave plate, an inner concave surface (121) of the concave plate towards to the first surface (111), the inner concave surface (121) and the first surface (111) enclose the heat dissipation channel (130).

9. The flow-through heat dissipation apparatus according to any one of claims 1 to 6, wherein the heat dissipation channel (130) is opened in the heat dissipation component (120) and passes through the heat dissipation component (120).

10. The flow-through heat dissipation apparatus according to claim 9, wherein the heat dissipation component (120) comprises at least one heat dissipation pipe, the lumen of the heat dissipation pipe is the heat dissipation channel (130).

11. The flow-through heat dissipation apparatus according to claim 10, wherein the cross-sectional shape of the lumen of the heat dissipation pipe comprises a circle, an ellipse, or a polygon.

12. The flow-through heat dissipation apparatus according to any one of claims 1 to 6, wherein the flow-through heat dissipation apparatus (100) comprises one heat dissipation component (120), and the heat dissipation component (120) is provided with a plurality of heat dissipation channels (130);
or, the flow-through heat dissipation apparatus (100) comprises a plurality of heat dissipation components (120) arranged on the first surface (111), and each heat dissipation component (120) is provided with one heat dissipation channel (130).

13. The flow-through heat dissipation apparatus according to claim 1, wherein the flow-through component (110) is a metal patch or a metal plate, and the metal patch or the metal plate is attached to the circuit layer.

14. A circuit board comprising: a circuit board body (200) and the flow-through heat dissipation apparatus (100) according to any one of claims 1 to 13;
wherein the flow-through heat dissipation apparatus (100) is connected to the circuit board body (200).

15. The circuit board according to claim 14, wherein the circuit board body (200) comprises a surface layer (210), a copper foil layer (220), and a solder resist layer (230);
the copper foil layer (220) is provided on the surface layer (210), and the copper foil layer (220) is a circuit layer provided with circuits;
the solder resist layer (230) is provided on the copper foil layer (220), and the solder resist layer (230) is provided with a plurality of windows (231), the copper foil layer (220) forms a plurality of pad portions (221) at positions respectively opposite to the plurality of windows (231);
the circuit board comprises a plurality of the flow-through heat dissipation apparatuses (100), and the flow-through components (110) of the plurality of the flow-through heat dissipation apparatuses (100) are respectively connected to the plurality of pad portions (221).
